# EUROPÄISCHE PATENTSCHRIFT

(11) **EP 0 945 736 B1**
(45) Veröffentlichungstag und Bekanntmachung des Hinweises auf die Patenterteilung: **13.07.2005**
(21) Anmeldenummer: 99101111.5
(22) Anmeldetag: 21.01.1999
(51) Int. Cl.: G01R 33/04

(54) **Magnetometer**
Magnetometer
Magnétomètre

(30) Priorität: 27.03.1998 DE 29805631 U
(43) Veröffentlichungstag der Anmeldung: 29.09.1999
(73) Patentinhaber: Ebinger, Klaus, D-51149 Köln (DE)
(72) Erfinder: Ebinger, Klaus, 51143 Köln (DE)
(74) Vertreter: Heim, Hans-Karl, Dipl.-Ing.

(56) Entgegenhaltungen:
- EP-A- 0 735 376
- DE-A- 3 044 020
- DE-A- 4 232 466
- DE-A- 4 338 752
- US-A- 2 806 202
- US-A- 3 135 199
- US-A- 4 634 978
- US-A- 5 351 005

## Beschreibung

Die Erfindung betrifft ein Magnetometer mit zwei in einem Abstand angeordneten, elektrisch in Reihe geschalteten magnetischen Induktoren, denen Strom aus einem Schwingungsgenerator zugeführt wird, wobei in den jeweiligen Induktoren erzeugte Signale über einen Schaukelabgleich den Eingänge eines Differenzverstärkers zugeführt werden, dessen Ausgangssignal ein Meßsignal ist.

In der Druckschrift EP-A-0 735 376 wird ein gattungsgemäßer Metalldetektor offenbart, der aufgrund unterschiedlicher Spulenwiderstände detektiert. Dieser Detektor verwendet eine ähnliche Schaltung wie aus herkömmlichen Magnetometern bekannt, wobei zusätzlich ein Filter mit Spulen den Detektorspulen nachgeschaltet ist.

Aus US-A-4,634,978 und US-A-5,351,005 sind weitere Magnetometer bekannt. Diese Magnetometer nutzen zum Abgleich der Spulen und zur Auswertung Widerstandmessbrücken.

Ein anderes Magnetometer ist beispielsweise aus der DE 42 32 466 A1 bekannt. Es handelt sich hier um ein Saturationsmagnetometer, welches nach dem Prinzip einer Feldstärke-Differenzmessung arbeitet. Die Induktoren dieses Magnetometers sind so geschaltet, daß das ungestörte Erdmagnetfeld weitgehend kompensiert wird. Durch dieses "Ausschalten" des Erdmagnetfeldes ist es möglich, äußerst geringe magnetische Effekte nachzuweisen. Ferromagnetische Teile, die sich z.B. im Erdboden befinden, verursachen eine Störung des Erdmagnetfeldes, welche von dem als Suchanordnung arbeitenden Magnetometer nachgewiesen werden kann.

Aufgrund der Tatsache, daß die Induktoren einen Abstand zueinander aufweisen, sind beide jeweils unterschiedlichen Magnetfeldern ausgesetzt; somit werden unterschiedliche Signale in den Induktoren erzeugt. Bei dem Magnetometer handelt es sich im Prinzip um eine magnetinduktive Brückenschaltung, die aufgrund einer durch eine magnetische Störung verursachte elektrischen Differenz ein Ausgangssignal erzeugt.

Bei dem Magnetometer werden die jeweiligen Signale in den Induktoren dadurch erzeugt, daß magnetisch hochpermeable Meßstreifen durch Spulenströme eine magnetische Sättigung erfahren. Durch Hysteresiseffekte der Meßstreifen werden in der Suchanordnung Oberwellen erzeugt, wenn ein äußeres Magnetfeld auf die Induktoren einwirkt. In der Regel verwendet man die Oberwelle mit der doppelten Erregerfrequenz (2f), die zu einem der angelegten Störfeldstärke in etwa proportionalen Meßsignal führt. Neben dem in einer Abgleicheinheit stattfindenden elektrischen Brückenabgleich ist ein mechanischer Abgleich wesentliche Vorraussetzung für ein zuverlässiges Arbeiten des Magnetometers. Insbesondere findet der mechanische Abgleich durch exakte Parallelisierung der Induktoren statt.

Magnetometer haben sich in der Praxis bewährt und sind allgemein, z.B. auf dem Gebiet der Kampfmittelräumung bekannt; ebenso bekannt sind der elektrische und der mechanische Abgleich, deren hohe Präzision eine wesentliche Voraussetzung für die gute Funktion des Magnetometers ist.

Bezüglich der Herstellung des Magnetometers erkennt man jedoch Verbesserungsbedarf. Dadurch, daß jeder der Induktoren mit einer Primär- und einer Sekundärwicklung ausgestattet ist, wobei die Primärwicklung als Erregerwicklung und die Sekundärwicklung als Empfängerwicklung wirkt, ist eine komplizierte Verschaltung der Induktorenanordnung erforderlich; die Schaltung erfordert, daß insgesamt fünf Verbindungsleitungen zu dem eigentlichen, die Induktoren enthaltenden Magnetsensorbereich notwendig sind. Weiterhin mußten die Sekundärwicklungen gegeneinander geschaltet werden, um im Hinblick auf den Differenzverstärker und bei der verwendeten Schaltung den Signalen die geeigneten Polaritäten zu vermitteln. Auch die interne Verschaltung der Induktoren ist bei dem gattungsgemäßen Magnetometer kompliziert; aufgrund der jeweils vorhandenen Primär- und Sekundärwicklungen weist jeder Induktor mindestens vier Anschlußstifte auf, die richtig miteinander verbunden werden müssen. Die Anzahl der hierfür erforderlichen Manipulationen kann die Fehleranfälligkeit des Magnetometers nachteilig beeinflussen bzw. dessen Präzision mindern. Abgesehen von den Nachteilen, die mit dem aufwendigen Herstellungsverfahren des gattungsgemäßen Magnetometers zusammenhängen, hat sich bei der Anwendung des Magnetometers gezeigt, daß die Meßgenauigkeit durch die individuellen Temperaturcharakteristiken der einzelnen Spulen unter ungünstigen Umständen negativ beeinflußt werden kann.

Der Erfindung liegt daher die **Aufgabe** zugrunde, ein Magnetometer zur Verfügung zu stellen, welches einen vereinfachten Induktoraufbau aufweist und somit die oben beschriebenen Nachteile hinsichtlich Herstellung und Anwendung beseitigt.

Diese Aufgabe wird durch die Merkmale des Patentanspruches 1 gelöst.

Durch den Einsatz von Kondensatoren werden in einfacher aber technisch effizienter Weise, Spulen und Verstärker galvanisch voneinander getrennt. Bei dem erfindungsgemäßen Magnetometer ist es vorteilhaft, als Schwingungsgenerator einen Rechteckgenerator einzusetzen.

Die Abgleicheinheit enthält vorzugsweise eine Brückenschaltung mit mehreren ohmschen Widerständen, wobei mindestens einer der ohmschen Widerstände einstellbar ist, so daß durch die Einstellung der elektrische Abgleich erfolgen kann.

Bei der so realisierten induktiven Brückenschaltung wird die elektrische Differenz der Induktoren mittels des einstellbaren Widerstandes symmetriert. In der Paxis wird dies als "Schaukelabgleich" bezeichnet, wobei dieser sicherstellt, daß die elektrische Wirkung beider Induktoren entgegengesetzt gleich ist.

Bevorzugt befinden sich die Induktoren in einem rohrförmigen Sondengehäuse.

Besonders vorteilhaft ist es, wenn beide Induktoren unabhängig voneinander um die Achse des Sondengehäuses drehbar und/oder um eine dazu senkrechte Achse schwenkbar gelagert sind.

Als Kernmaterial für die Induktoren wird bevorzugt magnetisch hochpermeables Material verwendet.

Durch das Magnetometer der vorliegenden Erfindung kommt es zu überraschenden Vorteilen. Jeder der Induktoren weist nur noch eine Spule auf; diese Spulen sind zudem noch gleichsinning gewickelt. Durch diese Vereinfachung der Induktoren sind nur noch drei Zuleitungen zur eigentlichen Meßsonde erforderlich; es wurde erwähnt, daß bei dem oben beschriebenen gattungsgemäßen Magnetometer fünf Zuleitungen erforderlich waren. Ebenfalls vereinfacht sich die interne Verschaltung der Induktoren, bedingt durch die geringere Anzahl von miteinander zu verbindenden Anschlüssen. Es hat sich überraschenderweise herausgestellt, daß, entgegen der bisherigen Auffasung, eine Trennung zwischen Erreger- und Empfängerspule bei den Induktoren nicht erforderlich ist.

Vielmehr kann man bereits den in der "Primärspule" - die erfindungsgemäß bei jedem Induktor die einzige Spule ist - erzeugten Oberwellenanteil ebensogut für die Differenzmessung verwenden. Eine galvanische Trennung zwischen den besendeten Induktoren und dem Differenzverstärker wird in einfacher Weise durch Koppelkondensatoren besorgt. Durch den einfacheren Aufbau der Induktoren werden die Herstellungskosten des erfindungsgemäßen Magnetometers im Vergleich zum Stand der Technik erheblich vermindert, einerseits aufgrund der einfacheren Herstellung, andererseits aufgrund des einfacheren Aufbaus der Induktoren.

Durch die Tatsache, daß nur eine Spule pro Induktor erforderlich ist, kommt es auch bei der Anwendung des Magnetometers zu deutlichen Verbesserungen. Einmal ist festzustellen, daß der vereinfachte Aufbau grundsätzlich mindestens dieselbe Meßgenauigkeit und dieselbe Empfindlichkeit zur Verfügung stellt wie die gattungsgemäße Meßsonde, weiterhin ist aber die Stabilität des Magnetometers noch verbessert worden, da aufgrund der geringeren Anzahl von Induktivitäten weniger Unsicherheiten aufgrund der verschiedenen Temperaturcharakteristiken der Induktivitäten vorliegen.

Die Erfindung wird nachfolgend anhand des Standes der Technik sowie eines Ausführungsbeispiels der Erfindung mit Bezug auf die begleitenden Zeichnungen näher erläutert; hierbei zeigen:
- Fig. 1: ein schematisches Schaltbild zur Veranschaulichung eines Magnetometers des Standes der Technik; und
- Fig. 2: ein schematisches Schaltbild zur Veranschaulichung einer Magnetometerausführung gemäß der Erfindung.

Mit nachgestelltem Strich versehene Bezugsziffern bezeichnen Bauteile des Standes der Technik.

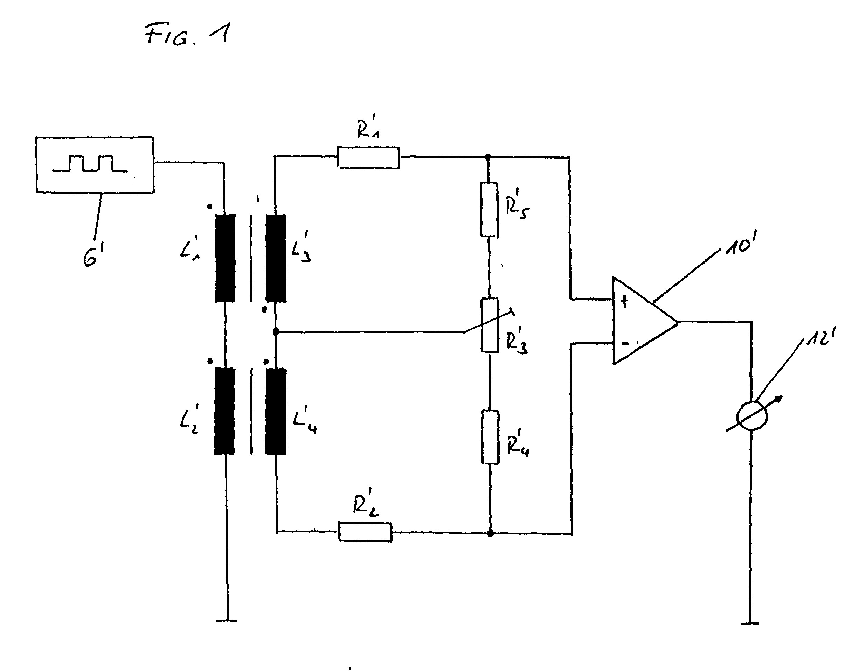

In Fig. 1 ist eine elektrische Schaltung dargestellt, die in einem Magnetometer des Standes der Technik Anwendung findet. Ein Schwingungsgenerator 6' versorgt zwei gleichsinnig gewickelte Primärspulen L₁', L₂' mit einem alternierenden Strom, hier mit einer Abfolge von Rechteckimpulsen. Diese Spulen L₁', L₂' dienen als Erregerspulen, wobei das in ihnen erzeugte Magnetfeld auf die als Empfängerspulen dienenden Sekundärspulen L₃', L₄' übertragen wird. Die Sekundärspulen L₃', L₄' sind gegensinning gewickelt und somit in Differenz geschaltet; die sich durch die Wicklungsrichtungen ergebenden relativen Polaritäten der Spulen sind in der Zeichnung durch Punkte angedeutet. Die Übertragung der elektromagnetischen Signale wird vorzugsweise durch hochpermeable Magnetkerne vermittelt. Im vorliegenden Beispiel können die Spulenpaare L₁', L₃'; L₂', L₄' in einem rohrförmigen Sondengehäuse angeordnet sein, wobei während der Anwendung des Magnetometers das Spulenpaar L₁', L₃' oben - d.h. vom Erdboden entfernt - und das Spulenpaar L₂', L₄' unten - d.h. in Bodennähe - angeordnet ist.

Die Sekundärspulen L₃', L₄' sind über eine Brückenschaltung mit den Eingängen eines Differenzverstärkers 10' verbunden. Die Brückenschaltung weist ohmsche Widerstände auf, wobei durch das Einstellen mindestens eines der Widerstände R₃' der elektrische Abgleich der Magnetometeranordnung erfolgt. Damit das Ausgangssignal 12' des Differenzverstärkers 10' ein zuverlässiges Maß für die Störung des Erdmagnetfeldes darstellt, ist ferner ein mechanischer Abgleich der von den Spulenpaaren L₁', L₃' und L₂', L₄' gebildeten Induktoren durch Parallelisieren erforderlich; dies erfolgt durch eine hier nicht-näher gezeigte Lagerung der Induktoren innerhalb des Sondengehäuses, bei der beide Induktoren unabhängig voneinander um die Achse des Sondengehäuses drehbar und/oder um eine dazu senkrechte Achse schwenkbar gelagert sind.

Die erforderliche galvanische Trennung zwischen Ausgangsseite (Differenzverstärker 10') und Eingangsseite (Rechteckgenerator 6'; Pimärspulen L₁', L₂') erfolgt durch die jeweilige Trennung zwischen der Primärseite und der Sekundärseite von oberem und unterem Induktor. Bei der beschriebenen Magnetometerschaltung des Standes der Technik ist es erforderlich, fünf Anschlußleitungen von der eigentlichen Sonde, d.h. von den Induktoren, zur Meßelektronik zu führen. Ferner müssen bei der beschriebenen Verschaltung die Sekundärspulen L₃', L₄' gegeneinander geschaltet sein, so daß ein Differenzverfahren möglich ist. Ebenso ist erkennbar, daß die interne Verschaltung der eigentlichen Magnetometersonde vergleichsweise aufwendig ist, da wenigstens vier Anschlüsse in der richtigen Weise miteinander verbunden werden müssen.

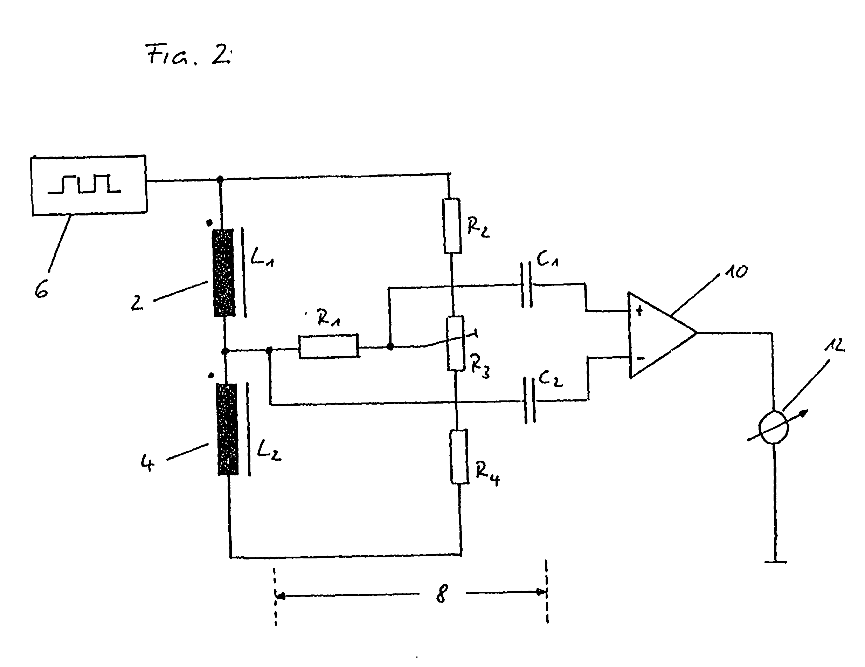

In Fig. 2 ist eine Schaltung dargestellt, die in einem Magnetometer gemäß der Erfindung verwendet wird. Ein Schwingungsgenerator 6 versorgt zwei in Serie geschaltete Spulen L₁, L₂ mit einer rechteckförmigen Spannung. Die Induktoren 2, 4 enthalten neben den Spulen, welche gleichsinnig gewickelt sind, einen Magnetkern aus hochpermeablem Material; wiederum sind die sich durch die Wicklungsrichtungen ergebenden relativen Polaritäten der Spulen in der Zeichnung durch Punkte angedeutet. Die beiden Induktoren L₁ und L₂ bilden in Verbindung mit den ohmschen Widerständen R₂, R₃, R₄, eine Brückenschaltung mit der die Anordnung elektrisch symmetriert wird. In der Brückendiagonalen befinden sich der Widerstand R₁ sowie zwei Koppelkondensatoren C₁ und C₂, die den MeBeingang eines Differenzverstärkers 10 von der Magntometerschaltung galvanisch trennen.

Der Kondensator C₁ ist im vorliegenden Ausführungsbeispiel direkt am positiven Eingang des Differenzverstärkers 10 angeschlossen, während der Kondensator C₂ mit dem negativen Eingang des Differenzverstärkers 10 verbunden ist. Der Widerstand R₁ ist mit einem Pol zwischen den in Serie geschalteten Induktoren 2, 4 angeschlossen und liegt damit ferner an dem Kondensator C₂, dessen anderer Pol, wie oben erwähnt, mit dem negativen Eingang des Differenzverstärkers 10 verbunden ist. Der andere Pol des Widerstandes R₁ ist an dem Mittelabgriff des einstellbaren Widerstandes R₃ sowie an dem Kondensator C₁ angeschlossen, der die wechselstrommäßige Ankopplung an den positiven Eingang des Differenzverstärkers 10 bereitstellt. Die beiden verbleibenden Anschlüsse des einstellbaren Widerstandes R₃ sind über die Widerstände R₂ bzw. R₄ mit den verbleibenden Anschlüssen der Induktoren 2, 4 verbunden.

Nach elektrischem Abgleich der Brückenschaltung durch Justierung des Widerstandes R₃ (Schaukelabgleich) sowie nach mechanischem Abgleich durch Parallelisierung der Induktoren 2, 4 kann das Ausgangssignal 12 des Differenzverstärkers 10 als Anzeige für ein gestörtes Magnetfeld verwendet werden. Die Induktoren 2, 4 können in einem hier nicht dargestellten rohrförmigen Sondengehäuse im wesentlichen koaxial angeordnet und im Hinblick auf die Parallelisierung unabhängig voneinander um die Achse des Sondengehäuses drehbar und/oder um eine dazu senkrechte Achse schwenkbar gelagert sein.

Wie anhand der Fig. 2 ersichtlich ist, sind lediglich drei Anschlüsse an der eigentlichen Magnetometersonde erforderlich, d.h. es müssen nur drei elektrische Leitungen von der Magnetometersonde weggeführt werden. Ferner ist die interne Verschaltung der Induktoren besonders einfach, da zum einen die Spulen nicht in Differenz geschaltet werden müssen, wie es beim Stand der Technik erforderlich war, und ferner lediglich die Anschlüsse von zwei Spulen, im Gegensatz zu vier Spulen beim Stand der Technik, richtig verschaltet werden müssen. Der apparative Aufwand ist aufgrund der vereinfachten Spulenanordnung verringert worden.

Durch die im Vergleich zum Stand der Technik geringere Anzahl von Spulen ist die Temperaturabhängigkeit der Bauteile insgesamt verringert, was mit anderen Worten zu einer Erhöhung der Temperatur- und Langzeitstabilität führt. Dies ermöglicht zuverlässigere Meßergebnisse.

## Patentansprüche

1. Magnetometer mit zwei in einem Abstand angeordneten, elektrisch in Reihe geschalteten magnetischen Induktoren (2, 4), denen Strom aus einem Schwingungsgenerator (6) zugeführt wird, wobei in den jeweiligen Induktoren (2, 4) erzeugte Signale über eine Abgleicheinheit (8) den Eingängen eines Differenzverstärkers (10) zugeführt werden, dessen Ausgangssignal (12) ein Meßsignal ist und die Induktoren (2, 4) jeweils eine Magnetspule aufweisen, wobei die Magnetspulen in Reihe geschaltet sind und mit äußeren Schaltungsgliedern (R₁, R₂, R₃, R₄) eine magnetinduktive Meßbrücke bilden,
**dadurch gekennzeichnet,**
**daß** die Abgleicheinheit (8) Kondensatoren (C₁, C₂) aufweist, welche die Induktoren (2, 4) von den Eingängen des Differenzverstärkers (10) galvanisch trennen.

2. Magnetometer nach Anspruch 1,
**dadurch gekennzeichnet,**
**daß** die Abgleicheinheit (8) eine Brückenschaltung mit mehreren ohmschen Widerständen (R₁, R₂, R₃, R₄) aufweist, wobei mindestens ein einstellbarer Widerstand (R₃) vorgesehen ist, so daß durch die Einstellung ein Abgleich erzielbar ist.

3. Magnetometer nach einem der Ansprüche 1 oder 2,
**dadurch gekennzeichnet,**
**daß** die Induktoren (2, 4) in einem rohrförmigen Sondengehäuse, im wesentlichen koaxial zueinander, angeordnet sind.

4. Magnetometer nach Anspruch 3,
**dadurch gekennzeichnet,**
**daß** beide Induktoren (2, 4) unabhängig voneinander um die Achse des Sondengehäuses drehbar und/oder um eine dazu senkrechte Achse schwenkbar gelagert sind.

5. Magnetometer nach einem der vorangehenden Ansprüche,
**dadurch gekennzeichnet,**
**daß** die Induktoren (2, 4) einen Magnetkern aus magnetisch hochpermeablem Material aufweisen.

## Claims

1. Magnetometer with two spaced, electrically series-connected, magnetic inductors (2, 4) to which power is supplied from an oscillation generator (6), the signals generated in the inductors (2, 4) being supplied via an alignment unit (8) to the inputs of a differential amplifier (10), whose output signal (12) is a measuring signal and the inductors (2, 4) in each case have a magnetic coil, the magnetic coils being connected in series and form with external circuit elements (R₁, R₂, R₃, R₄) a magnetoinductive measuring bridge,
**characterized in that**
the alignment unit (8) has capacitors (C₁, C₂), which isolate the inductors (2, 4) from the inputs of the differential amplifier (10).

2. Magnetometer according to claim 1,
**characterized in that**
the alignment unit (8) has a bridge circuit with several ohmic resistors (R₁, R₂, R₃, R₄) and at least one adjustable resistor (R₃) is provided, so that an alignment can be obtained through the adjustment.

3. Magnetometer according to one of the claims 1 or 2,
**characterized in that**
the inductors (2, 4) are placed substantially coaxially to one another in a tubular probe casing.

4. Magnetometer according to claim 3,
**characterized in that**
independently of one another, the two inductors (2, 4) are rotatable mounted about the axis of the probe casing and/or are pivotably mounted about an axis perpendicular thereto.

5. Magnetometer according to one of the preceding claims,
**characterized in that**
the inductors (2, 4) have a magnetic core of magnetically highly permeable material.

## Revendications

1. Magnétomètre à deux inductances magnétiques (2, 4), branchées en série et installées à distance, ces inductances recevant du courant d'un générateur d'oscillation (6),
les signaux générés par les inductances (2, 4) respectives étant appliqués par une unité d'équilibrage (8) aux entrées d'un amplificateur différentiel (10) dont le signal de sortie (12) est un signal de mesure et les inductances (2, 4) ayant chacune une bobine magnétique,
les bobines magnétiques étant branchées en série et avec des éléments de commutations extérieures (R₁, R₂, R₃, R₄) formant un pont de mesure magnéto-inductif,
**caractérisé en ce que**
l'unité d'équilibrage (8) comprend des condensateurs (C₁, C₂) séparant galvaniquement les inductances (2, 4) des entrées de l'amplificateur différentiel (10).

2. Magnétomètre selon la revendication 1,
**caractérisé en ce que**
l'unité d'équilibrage (8) comprend un montage en pont à plusieurs résistances ohmiques (R₁, R₂, R₃, R₄) avec au moins une résistance réglable (R₃) pour réaliser l'équilibrage par le réglage.

3. agnétomètre selon l'une des revendications 1 ou 2,
**caractérisé en ce que**
les inductances (2, 4) sont installées dans un boîtier de sonde, tubulaire, d'une manière essentiellement coaxiale.

4. Magnétomètre selon la revendication 3,
**caractérisé en ce que**
les deux inductances (2, 4) sont montées indépendamment l'une de l'autre de manière rotative autour de l'axe du boîtier de sonde et/ou de manière pivotante autour d'un axe perpendiculaire.

5. Magnétomètre selon l'une des revendications précédentes,
**caractérisé en ce que**
les inductances (2, 4) ont un noyau magnétique en une matière à perméabilité magnétique élevée.
